# EUROPEAN PATENT APPLICATION

(11) **EP 4 436 018 A1**
(43) Date of publication of application: **25.09.2024**
(21) Application number: 21964288.1
(22) Date of filing: 18.11.2021
(51) Int. Cl.: H02M 1/00, H02M 3/00, H02M 5/00, H02M 7/00

(54) **SWITCH CELL COMPRISING AN INTERNAL POWER LINK**

(71) Applicant: Universidad Técnica Federico Santa María, Valparaiso (CL)
(72) Inventor: ROJAS MONRROY, Christian Alexis, Valparaíso (CL); RENAUDINEAU, Hugues Jean-Marie, Valparaíso (CL); KOURO RENAER, Samir Felipe, Viña del Mar (CL)
(74) Representative: Barbaro, Gaetano
(86) International application number: PCT/CL2021/050112
(87) International publication number: WO 2023/087121

(57) **Abstract**

The present invention relates to the field of electronics; more specifically to the field of apparatus for converting an AC or DC input into an AC or DC output and in particular provides a switching cell with internal power link characterized in that it comprises: two switches, wherein each contains the same number of phases, wherein said switch contains two interrupters for each phase, an AC link having the same number of phases of said switches, an input voltage at the terminals of the first switch, and an output voltage between the terminals of the second switch and the first switch, wherein said internal AC link of the cell connecting the midpoints of said switches for each phase, wherein said AC link contains a capacitor connecting the midpoints of said switches for each phase, said AC link contains an inductor connecting the phases, wherein said inductor is connected anteriorly, posteriorly or between the capacitors, with each phase connected to each other by means of an inductor; and each switch containing said switching cell corresponds to a semiconductor.

## Description

### TECHNICAL FIELD OF THE INVENTION

The present invention relates to the field of electronics, specifically with the field of apparatus for converting an AC or DC input into an AC or DC output. In particular, it provides a switching cell with internal power link.

### BACKGROUND OF THE INVENTION

Within the field of power conversion, an important part of power converters are switching cells with internal power link. In the state of the art, some configurations of switching cells are known, but as the technology matures, new switching cell requirements arise.

Currently, there are two-phase internal power link switching cells with low efficiency, e.g., containing galvanically isolated devices in their internal link, which are connected in two-phase cells, but generate energy losses due to the type of connection. Another example is the internal power link cells that contain only capacitive components, which is used only for battery charging, which is a limited application as it has no inductive components.

Applications of internally linked switching cells in power supplies are known in the prior art. For example, WO2012149387A1 describes a power supply comprising within it a switching cell containing, in general, a series switch connected between the terminals of two pairs of switches, which in turn are connected by an inductor between the midpoints of these switches. This cell performs only the function of a DC-DC or DC-AC converter.

On the other hand, the paper A. C. Braga, (IEEE TRANSACTIONS ON POWER ELECTRONICS, VOL. 12, NO. 2, MARCH 1997) describes a useful technique for parallel connection between switching cells interconnected by inductors. This technique consists of using these inductors to ensure a dynamic and static current participation in switching cells switches. The generic cell can be adapted to a DC-DC converter as well as to inverters.

However, the state-of-the-art background is silent regarding applications of switching cells in DC-DC, DC-AC, AC-DC or AC-AC power converters, that require multiphase systems containing an internal AC link.

Consequently, there is a need to create a topological variety for a switching cell with internal power link containing combinations of components for the generation of a multiphase AC link.

### SUMMARY OF THE INVENTION

The present invention provides a switching cell with internal power link, characterized in that it comprises: a first switch and a second switch, wherein said first and second switches contain the same number of phases, and two switches for each phase, an AC link having the same number of phases of said first and second switches, an input voltage at the terminals of the first switch, and an output voltage between the terminals of the first switch and the second switch and, said internal AC link of the switching cell connects the midpoints of said switches for each phase, and containing a capacitor connecting the midpoints of said first and second switches for each phase, said AC link further containing an inductor connecting each phase anteriorly, posteriorly or between the capacitors, and wherein each interrupter containing said switching cell corresponds to a semiconductor.

In a preferred embodiment, the switching cell of the invention is characterized in that said AC link contains a plurality of capacitors connected in series for each phase.

In another preferred embodiment, the switching cell is characterized in that the inductor of such an AC link connects the phases by means of a series, parallel, delta or star connection.

In another preferred embodiment, the switching cell is characterized in that said AC link contains one inductor less than the number of capacitors per phase, when said inductor is located between the capacitors.

In a further preferred embodiment, the switching cell is characterized in that said AC link contains an inductor, where there is one capacitor per phase.

### BRIEF DESCRIPTION OF THE FIGURES

FIG. 1 illustrates a first embodiment of a switching cell with internal two-phase AC link, with an inductor connecting the upper cell, which is the subject of the present invention.
FIG. 1a illustrates the multiphase switching cells used in all embodiments of the two-phase internal linked switching cells of the invention.
FIG. 2 illustrates a second embodiment of a switching cell with internal two-phase AC link, with an inductor connecting in the lower cell, which is the subject of the present invention.
FIG. 3 illustrates a third embodiment of a switching cell with internal two-phase AC link, with two capacitors connected in series for each phase and an inductor connecting the phases between the capacitors, which is the subject of the present invention.
FIG. 4 illustrates a fourth embodiment of a switching cell with three-phase internal AC link, with a plurality of inductors connecting the phases by means of a delta-type connection in the upper cell, which is the subject of the present invention.
FIG. 5 illustrates a fifth embodiment of a switching cell with three-phase internal AC link, with a plurality of inductors connecting the phases by means of a delta-type connection in the lower cell, which is the subject of the present invention.
FIG. 6 illustrates a sixth embodiment of a switching cell with three-phase internal AC link, with two capacitors connected in series for each phase and a plurality of inductors connecting the phases through a delta-type connection between the capacitors, which is the subject of the present invention.
FIG. 7 illustrates a seventh embodiment of a switching cell with three-phase internal AC link, with a plurality of inductors connecting the phases by means of a star-type connection in the lower cell, which is the subject of the present invention.
FIG. 8 illustrates an eighth embodiment of a switching cell with three-phase internal AC link with a plurality of inductors connecting the phases by means of a star-type connection in the upper cell, which is the subject of the present invention.
FIG. 9 illustrates a ninth embodiment of a switching cell with three-phase internal AC link, with two capacitors connected in series for each phase and a plurality of inductors connecting the phases by means of a star-type connection between capacitors, which is the subject of the present invention.
FIG. 10 illustrates a first example of a converter with internal two-phase AC link for a system with a battery with inductive filter in the inlet, which is the object of the present invention.
FIG. 11 illustrates a second example embodiment of a converter with internal two-phase AC link for a system with a battery with inductive filtering at the output, which is the subject of the present invention.
FIG. 12 illustrates a third example of an embodiment of a converter with internal three-phase AC link for a photovoltaic system and with inductive filter at the output, which is the subject of the present invention.
FIG. 13 illustrates a fourth example embodiment of a converter with internal two-stage AC link for a water electrolysis system and with inductive filter at the output, which is the subject of the present invention.

### DETAILED DESCRIPTION OF THE INVENTION

In the following, the present invention will be described in detail, referring to the figures accompanying the present application.

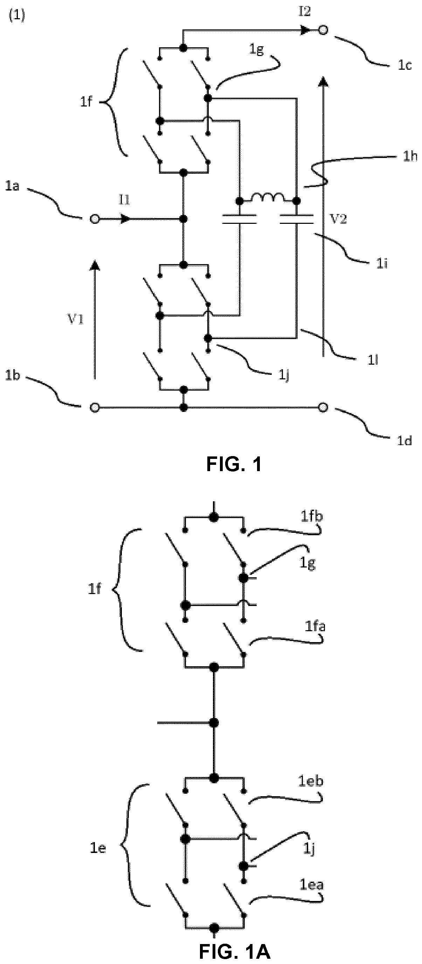

In a first object of the present invention, as schematically illustrated in FIG. 1-9, a switching cell (1) with internal power link with a plurality of phases is provided, comprising, essentially: an switching cell with internal power link (1) having a positive input (1a), a negative input (1b), a positive output (1c) and a negative output (1d); the negative voltage input (1b) electrically connected to said negative output (1d) of said switching cell with internal power link (1), further comprising: a first switch and a second multiphase switch connected in series, a voltage and current input at the negative (1b) and positive (1a) terminals of the first switch (1e), a plurality of capacitors (1ia, 1ib, 1ic) connecting the midpoint (1j) of the first switch (1e) and the midpoint (1g) of the second switch (1f), a inductor (1h) electrically connecting each phase anteriorly, posteriorly or between capacitors. In addition, a voltage and current output between a positive terminal (1c) of the second multiphase cell and the negative terminal (1d) of the first multiphase switch (1e).

Hereinafter, for the sake of simplicity and without limiting the scope of the present invention, reference will be made to the internal power switching cell (1) of controllable topology which is the subject of the present invention as a switching cell.

In the context of the present invention, a switching cell is understood as an assembly of electrical and electronic components arranged in such that, in response to a continuous (DC) or alternating (AC) input signal, it generates a DC or AC output signal. Typically, the ratio between the input and output voltage of a switching cell is controlled by the ratio of the open time to the close time of one or more switches that are part of the switching cell.

The first switch with a plurality of phases (1e) which is part of the switching cell with internal power link (1) which is the subject of the present invention, presents two inputs, which in the context of the present invention and without limiting the scope thereof, will be referred to as positive input (1a) and negative input (1b). In addition, the switching cell with internal power link (1) presents two outputs, which in the context of the present invention and without limiting the scope thereof, shall be referred to as positive output (1c) and negative output (1d).

The first and second switches of a plurality of phases (1e) and (1f) are part of the switching cell (1) which is the subject of the present invention, feature two switches (1ea, 1eb) in the first switch and a second pair of switches (1fa, 1fb) in the second switch for each phase, connected in series for each phase with a power link connected between the first and second switch for each phase. In the context of the present invention, and without limiting the scope thereof, such a connection between the internal power link connected and each multiphase switch is referred to as the midpoint (1j, 1g) of each multiphase switching cell. In a preferred embodiment, without limiting the scope of the present invention, said multiphase switching cell contains a midpoint (1j, 1g) for each phase.

In a preferred embodiment, and without limiting the scope of the present invention, as schematically illustrated in FIG. 1, there is provided a dual phase switching cell with internal AC power link (1). In another preferred embodiment, without limiting the scope of the present invention, said dual phase switching cell, comprising in an essential manner: two communication phases in both switches (1e) and (1f); two phases in the internal power link (1l); connects a capacitor (1i) in each phase between midpoints of the first and second dual phase switch; and an inductor (1h) that electrically connects both phases, posteriorly of each capacitor.

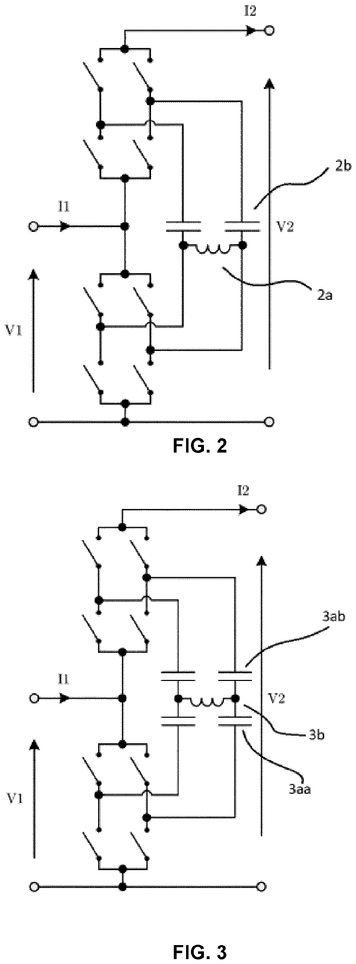

In another preferred embodiment, the particular topology configuration of the present invention, as schematically illustrated in FIG. 2, said inductor (2a) connects the first and second phases anteriorly of each capacitor (2b).

In another preferred embodiment, the particular topology configuration of the present invention, as schematically illustrated in FIG. 3, said internal AC power link contains two capacitors (3aa, 3ab) for each phase. In addition, an inductor (3b) connects the first and second phases, between said capacitors of each phase.

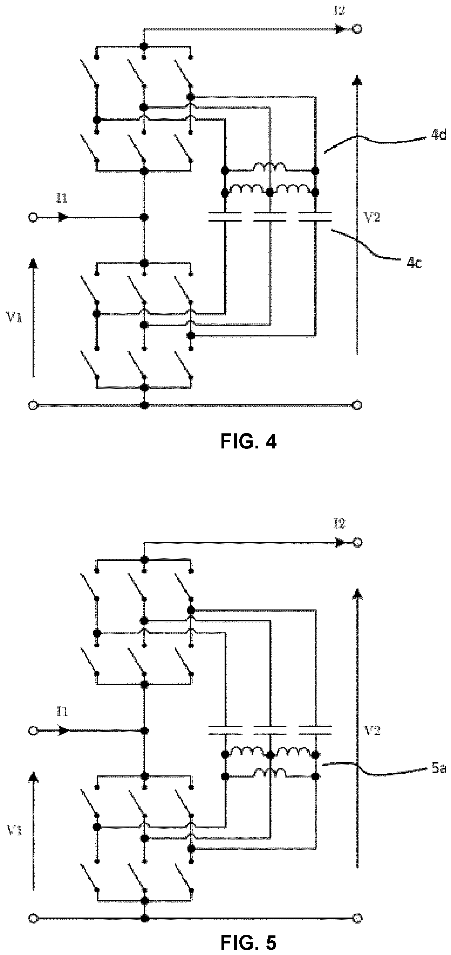

In another preferred embodiment, and without limiting the scope of the present invention, as schematically illustrated in FIG. 4 a triple phase switching cell with internal AC power link (4) is provided. In a more preferred embodiment, without limiting the scope of the present invention, said triple-phase switching cell (4), comprises, essentially: three communication phases in each switching cell; three phases in the internal power link; connect a capacitor (4c) in each phase between the midpoints of each triple phase switching cell; and one inductor (4d) per phase connecting by a delta-type connection each phase over each capacitor.

In another preferred embodiment, and without limiting the scope of the present invention, the particular configuration of the topology of the present invention, as schematically illustrated in FIG. 5, said inductors connecting each of the phases by means of a delta-type connection (5a), are connected anteriorly of each capacitor.

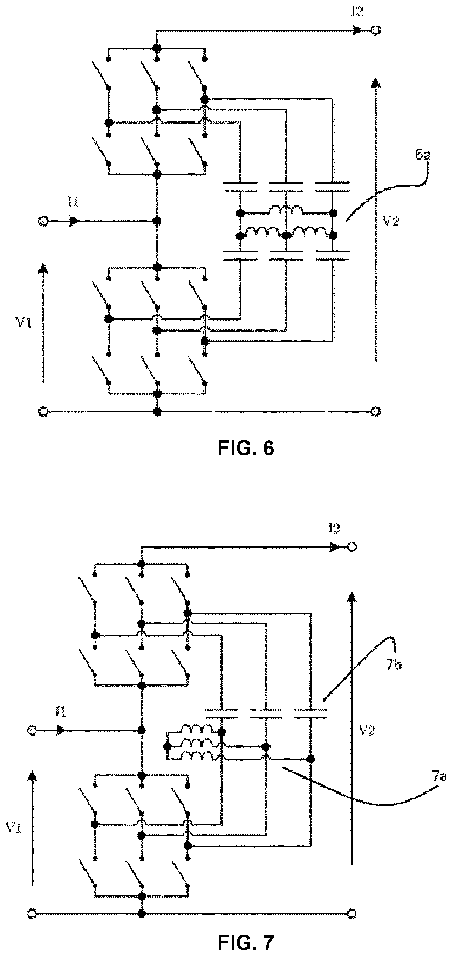

In another preferred embodiment, and without limiting the scope of the present invention, the particular topology configuration of the present invention, as schematically illustrated in FIG. 6, said AC power link contains two capacitors per each phase. Furthermore, said delta-type connection of the inductors (6a) connects the three phases between said capacitors of each phase.

In another preferred embodiment, and without this limiting with the scope of the present invention, the particular configuration of the topology of the present invention, as schematically illustrated in FIG. 7, in the AC power link such inductors are connected by star type to each phase (7a) posteriorly of each capacitor (7b).

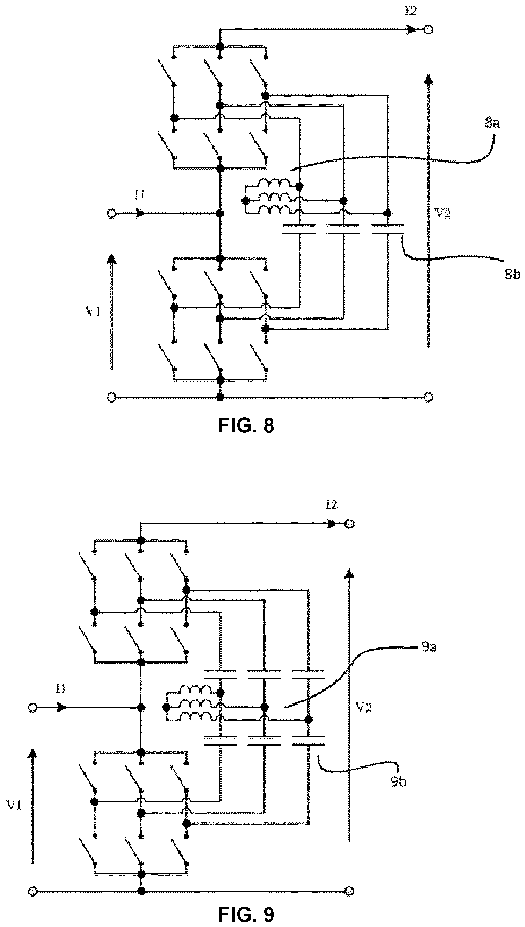

In another preferred embodiment, and without limiting the scope of the present invention, the particular configuration of the topology of the present invention, such as schematically illustrated in FIG. 8, in the AC power link said inductors (8a) connect via star type from each anteriorly phase to each capacitor (8b).

In another more preferred embodiment, and without limiting the scope of the present invention, the particular configuration of the topology of the present invention, such as schematically illustrated in FIG. 9, in the AC power link contains two capacitors for each phase. Furthermore, said connection of the inductors between the three phases is of star type (9a) between said capacitors (9b) of each phase.

### EXAMPLES OF REALIZATION

### Example 1: Use of switching cell with internal two phase AC link in batteries and inductive filter at the input.

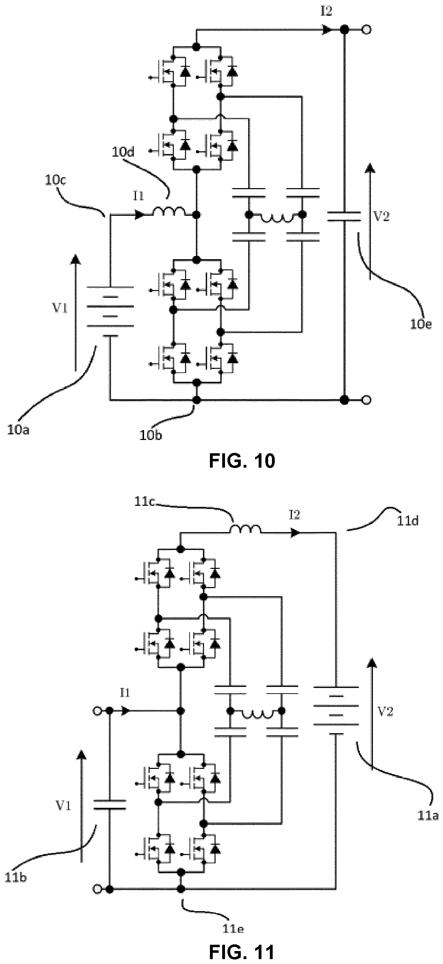

As shown schematically in FIG. 10, the switching cell with internal power link which is the subject of the present invention can be used as a power converter connecting a battery (10a) at the input of the first cell with a DC voltage line. For this, a negative potential terminal (10b) is connected at the negative potential input of the first cell, while the positive terminal (10c) of the battery is connected to an inductor (10d) serving as an inductive filter, so that said inductor is connected to the positive terminal at the positive potential input of the first cell. On its part, the internal AC power link of the switching cell is dual phase with inductor between capacitors. In addition, a capacitor (10e) is provided to connect the output terminals of the switching cell, between the positive terminal of the second cell and the positive terminal of the first cell.

### Example 2: Switching cell implementation with internal two-phase AC link in batteries and inductive filter at the output.

In FIG. 11, a schematic drawing of the switching cell with internal power link that is the subject of the present invention is illustrated can be used as a power converter connecting a battery (11a) at the output of the first cell with a DC voltage line. For this, a capacitor (11b) is connected between the input terminals of the first cell. On its part, the internal AC power link of the switching cell is dual phase with inductor between capacitors. In addition, an inductor (11c) is connected through a side at the output of the second cell, and the other end is connected to the positive terminal (11d) of the battery (11a), while the negative potential terminal is connected to the negative terminal (11e) of the first cell, by means of a DC voltage line.

### Example 3: Use of switching cell with internal three phase AC link in photovoltaic system and inductive filter at the output.

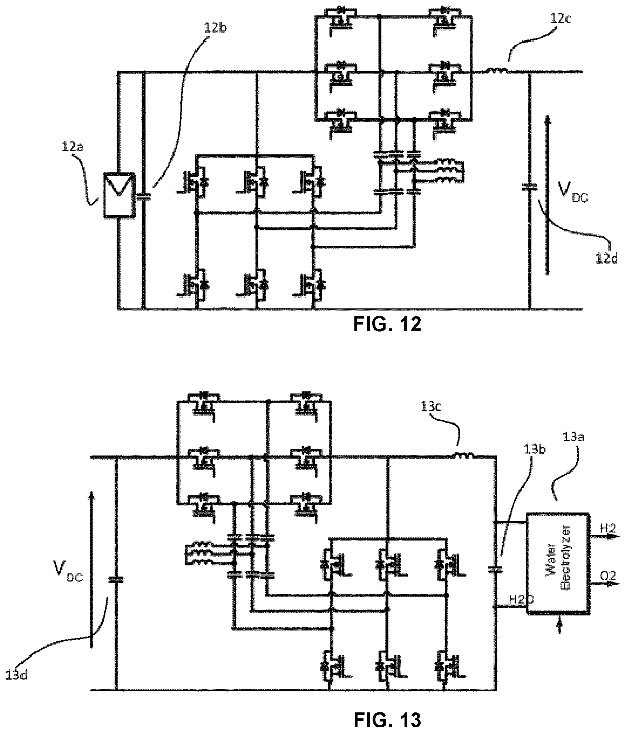

FIG. 12 further illustrates a schematic diagram of an implementation of the switching cells with internal three phase power AC link connected to a photovoltaic system.

In this example, the switching cell is a converter containing three phases interconnected with an AC link where inductors are star-style connected between the capacitors. FIG.12 shows a photovoltaic system (12a) connected in parallel to a capacitor (12b) and between the terminals of the first cell. In addition, an inductor (12c) connected at the output of the second cell is provided. On the other hand, there is a capacitor (12d) connected between the negative potential terminal of the first cell and said inductor.

### Example 4: Implementation of a switching cell with three phase internal AC link in a water electrolysis system with inductive filter at the outlet.

FIG.13 further illustrates a schematic diagram of an implementation of the switching cells with three phase internal power AC link connected to a water electrolysis system. The switching cell used in this example is the same cell used in Example 3.

In this example, FIG.13 illustrates a water electrolysis system (13a), connected in parallel to a capacitor (13b) and connected to an inductor (13c) at one of its terminals, wherein said inductor and capacitor are used as input filters. In addition, the said inductor is connected to the positive terminal of the first cell, while the negative terminal of the first cell is connected to the negative terminal of the water electrolysis system. On the other hand, a capacitor (13d) is connected between the negative potential terminal of the first cell and the output terminal of the second cell.

## Claims

1. A switching cell with internal power link (1), **characterized in that** it comprises:
- a first switch and a second switch operatively connected (1e,1f), wherein said first and second switches contain the same number of phases (1), and two interrupters (1 ea, 1 eb) on the first switch and two other interrupters (1fa, 1fb) on a second switch for each phase;
- an AC link having the same number of phases of such first and second switch;
- an input voltage at the terminals of the first switch (1a, 1b), and an output voltage between the terminals of the second switch (1c) and the first switch (1d);
- said internal AC link of the switching cell connects the midpoints (1j,1g) of said first and second switches for each phase;
- said AC link contains a capacitor (1i) connecting the midpoints of said first and second switches for each phase;
- said AC link also contains an inductor (1h) that connects each phase anteriorly, posteriorly or between capacitors; and
- where each interrupter contained in the switching cell corresponds to a sem iconductor.

2. The switching cell of claim 1, **CHARACTERIZED in that** said AC link contains a plurality of series connected capacitors for each phase.

3. The switching cubicle of claim 1, **CHARACTERIZED in that** the inductor of said AC link connects the phases by means of a series, parallel, delta or star connection.

4. The switching cell of claim 1, **CHARACTERIZED in that** said AC link contains one less inductor than the number of capacitors per phase when said inductor is between capacitors.

5. The switching cell of claim 1, **CHARACTERIZED in that** such AC link contains an inductor when there is one capacitor per phase.
